Europäisches Patentamt

European Patent Office

Office européen des brevets

(11) Publication number: **0 224 360 B1**

## EUROPEAN PATENT SPECIFICATION

(45) Date of publication of patent specification: **08.04.92**   (51) Int. Cl.⁵: **C23C 16/50**, C23C 16/54

(21) Application number: **86308829.0**

(22) Date of filing: **12.11.86**

Divisional application 91202023.7 filed on 12/11/86.

(54) **Semiconductor device manufacturing method.**

(30) Priority: **12.11.85 JP 253299/85**
**18.11.85 JP 259194/85**

(43) Date of publication of application:
**03.06.87 Bulletin 87/23**

(45) Publication of the grant of the patent:
**08.04.92 Bulletin 92/15**

(84) Designated Contracting States:
**DE FR GB**

(56) References cited:
**EP-A- 106 637**
**EP-A- 160 365**
**EP-A- 0 109 808**
**GB-A- 2 076 587**
**US-A- 4 492 605**

(73) Proprietor: **SEMICONDUCTOR ENERGY LAB-ORATORY CO., LTD.**
**398 Hase**
**Atsugi-shi Kanagawa-ken, 243(JP)**

(72) Inventor: **Yamazaki, Shunpei**
**21-21 Kitakarasuyama 7-chome**
**Setagaya-ku Tokyo 157(JP)**

(74) Representative: **Milhench, Howard Leslie et al**
**R.G.C. Jenkins & Co. 26 Caxton Street**
**London SW1H 0RJ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 224 360 B1

## Description

This invention concerns improvements relating to semiconductor device manufacturing methods.

A plasma CVD (chemical vapour deposition) system in which reactant gas is made active by glow discharge alone, has been proposed and is considered advantageous as compared with more conventional thermal CVD systems for semiconductor material deposition in that the deposition process can be carried out at a relatively low temperature. Further, the deposited layer thus formed contains hydrogen or halogen as a recombination centre neutralizer, which can improve p-n, n-i or p-i junctions formed in the layer. Such a glow discharge CVD system however, obtains only very low deposition speeds, and there is a requirement to increase such speeds by a factor of 10 to 500 to satisfy the needs of commercial availability.

A CVD system enhanced by ECR (electron cyclotron resonance) has also been proposed in which deposition is carried out at pressures lower than 1.333 Pa ($1 \times 10^{-2}$ torr), e.g., 1.333 to 1.333 $\times$ $10^{-3}$ Pa ($1 \times 10^{-2}$ to $1 \times 10^{-5}$ torr). By virtue of such a CVD/ECR system, a $5 \times 10^{-7}$ m (5000 Å) to 10 microns thick layer can be deposited at a rate of $10^{-9}$ to $10^{-8}$ m/s (10 to 100 Å/sec). However, when a plurality of layers are desired to be deposited, the system is still very slow.

It would therefore be desirable to provide an improved semiconductor manufacturing method which is capable of producing semiconductor devices with high quality junctions; to provide an improved semiconductor manufacturing method which is capable of yielding large throughput: and to provide an improved semiconductor manufacturing method with a short process time.

Aspects of the invention are set out in the accompanying claims. According to an illustrative and exemplary embodiment of the present invention, non-productive gas such as argon for example is energized by electron cyclotron resonance (ECR). The thus activated non-productive gas is then applied to transfer a part of its energy to productive gas in a glow discharge CVD system, so that an intrinsic layer can be deposited without any sputtering effect on a sub-layer (an impurity semiconductor layer for example) which has previously been formed on a substrate. By virtue of this technique, the tendency for glow discharge CVD to damage a substrate by its accompanying sputtering effect can largely be overcome.

In the practice of the inventive technique above-described a multi-chamber system can be utilized in which a plurality of depositions can be made in succession without exposing a substrate being processed to contact with air. As a result, semiconductor junctions can be protected from atmospheric contamination and particularly from lower oxide or lower nitride incursions.

The combination of an ECR system and a glow discharge CVD system also makes it possible to perform depositions at a high operational speed and obtain high quality products.

In the practice of the present invention, depositions are preferably made at a low pressure of the order of $1.333 \times 10^{-3}$ to 1.333 Pa ($10^{-5}$ to $10^{-2}$ torr) and preferably around $1.333 \times 10^{-2}$ to 1.333 $\times 10^{-1}$ Pa ($10^{-4}$ to $10^{-3}$ torr), which is a very low pressure as compared with the pressure used in carrying out prior art techniques, namely about 13.33 to 66.66 Pa (0.1 to 0.5 torr). The use of such low pressure reduces residual gas retention in the process chamber between one deposition process and the next, making it possible to streamline the manufacturing process by including a plurality of deposition steps carried out in different chambers and dispensing with the need to evacuate one chamber sufficiently and then open a valve partitioning it from the next chamber before effecting successive depositions in sequential chambers.

As a reactant (productive) gas, a silicide gas such as $Si_nH_{2n+1}$ ($n \geq 1$), $SiF_n$ ($n \geq 2$), $SiH_nF_{4-n}$ ($1 < n <$ $Si(CH_3)_nH_{4-n}$ ($n = 1,2,3$), a germanium composition such as $GeH_4$, $GeF_4$ or $GeH_nF_{4-n}$ ($n = 1,2,3,4$), a tin compound such as $SnCl_4$ or $SnF_2$ or $SnF_4$, or a carbide gas can be employed, for example. In addition, a dopant gas such as $B_2H_6$, $BF_3$ or $PH_3$ for example may be added for fabrication of impurity semiconductor layers.

Other features of the invention are set forth with particularity in the appended claims, and the invention together with features and advantages thereof will best be understood from consideration of the following description of exemplary embodiments given with reference to the accompanying drawings wherein:-

Fig. 1 is a schematic diagrammatic representation of an exemplary ECR enhanced CVD system; and

Fig. 2 is a schematic diagrammatic representation of an exemplary multi-chamber processing system used in a method embodying the present invention.

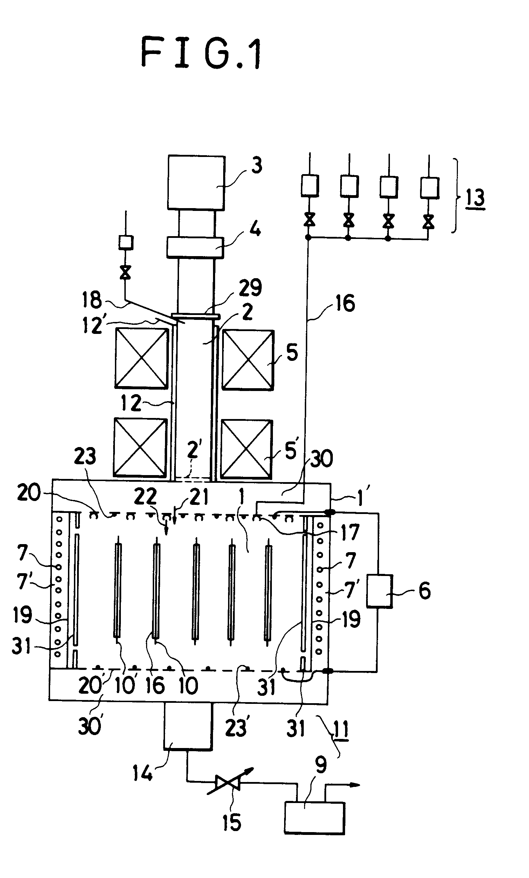

Referring to Fig. 1, an (ECR) enhanced CVD system used in a method according to the invention is shown. A reaction chamber 1 communicates with loading and unloading chambers (not shown) on opposite sides of the reaction chamber 1 perpendicular to the plane of the drawing, the reaction chamber and the loading and unloading chambers communicating with each other through gate valves. Between the loading and unloading chambers, a reaction space is surrounded by collars 31 and 31′ made of stainless steel and/or insulating material so that excited reactive gas does not spread out to the inside of the structure and does not give rise to the accumulation of products which might become a source of flakes in a deposited semiconductor layer. The collars 31' are formed and arranged to constitute an enclosure in co-operation with the collars 31, the three collars on each side of the enclosure being made flush with each other. The collar 31 is formed with five substrate holders 10' and is capable of being removably mounted in the reaction chamber 1 as shown in the figure, and substrates 10 can be mounted on both sides of each holder 10'. With the reaction space therebetween, halogen lamp heaters 7 are provided to irradiate the collars 31 and the substrates 10 on the holders 10' with infrared radiation. Further, a pair of meshed grids 20 and 20' are provided at the upper and lower sides of the reaction space 1. A glow discharge is established in the reaction space 1 by applying to the grids 20 and 20' an alternating electric field of 13.56 MHz for example or by applying a direct electric field between the meshed electrodes 20 and 20' by means of a power supply 6.

Above the reaction chamber, a resonant space is defined by the interior of a resonance chamber 2, and non-productive gas can be introduced into the resonant space through a line 18. The resonant space can be subjected to a magnetic field by energizing a core-less coil 5 and 5', a Helmholtz coil 5 and 5' surrounding the resonant space in this embodiment. A cooling circuit 12 is arranged around the resonance chamber 2. Further, microwave energy can be radiated into the resonant space from a microwave oscillator 3 via an isolator 4 through a window made of synthetic quartz.

The non-productive gas introduced and excited in the resonant space might for example be argon and the magnitude of the magnetic field might for example be chosen at $8.75 \times 10^{-2}$ T (875 Gauss), the magnitude of the magnetic field and the frequency of the microwave energy in general being determined according to the molecular weight of the non-productive gas to be excited. The argon gas thus excited is pinched by the magnetic field and resonates with the microwave energy on the background of the magnetic field. The excited argon gas is rendered to the reaction space 1 through an extraction grid 2'. Between the grid 2' and the reaction space 1 there is a buffer space 30 and a plurality of nozzles 23 through which productive gas may be introduced throughout the reaction space. The productive gas is mixed with the excited non-productive gas and is itself excited by transfer of energy from the non-productive gas. The meshed electrode 20 functions also as a homogenizer to prevent the excited gas from backflowing. In the case where the collars are made of insulating material, a pair of insulator grids may be used as a homogenizer and a plurality of electrodes may be provided to produce the requisite electron discharge. In order to distribute the reaction gas throughout the reaction chamber 1 and establish cyclotron resonance, the pressure in the resonant space and the reaction space is chosen to be around $1.333 \times 10^{-1}$ to $1.333 \times 10^{-2}$ Pa ($1 \times 10^{-3}$ to $1 \times 10^{-4}$ torr), $4 \times 10^{-2}$ Pa ($3 \times 10^{-4}$ torr) for example. The pressure is adjusted by controlling the exhausting rate of a vacuum pump 9 by means of a controlling valve 15 in co-operation with a turbo pump 14.

By virtue of the described arrangement, electrons and the excited gas 21 traverse the reaction chamber. Even with a substantial distance between the resonant space and the surfaces of the substrates, the excitations of the productive gas derived from the resonating gas is manifest in the vicinity of the substrates. When cyclotron resonance has been used alone as in the prior art, this distance has been chosen to be about 5 to 15 cm. While a short distance between the resonant space and the substrates reduces energy loss in the excited gas, it has resulted in deposited layers being uneven.

An amorphous silicon layer was fabricated according to the above described system as follows. Namely, a reaction chamber of 40 cm height and 50 cm width and length was utilized which defined a reaction space of 30 cm height and 35 cm width and length. Ten substrates 10 were placed on the holder. Argon gas was introduced into the reaction space 1 under a pressure of $4 \times 10^{-2}$ Pa ($3 \times 10^{-4}$ torr) as a non-productive gas through the line 18 at a rate of 200 cc/min. Also monosilane gas was introduced through the line 16 at a rate of 80 cc/min. In addition to this, $B_2H_6$ gas diluted with $SiH_4$ for example may be leaked simultaneously at from 0.1 to 10 ppm to make a substantially intrinsic semiconductor, if desired. High-frequency electric energy at 40 W was initially supplied by the power source 6, and microwave energy at a frequency of 2.45 GHz and a power of from 200 W to 800 W, preferably 400 W, was also supplied. The magnitude of the magnetic field was chosen at $0.0875 \pm 0.01$ T ($875 \pm 100$ Gauss).

The susbtrate 10 was provided with a conductive transparent layer. On the substrate 10 was deposited a non-monocrystal semiconductor layer, for example an amorphous silicon semiconductor layer, at a substrate temperature of 250°C and with excess gas being exhausted through the exhaust system 11. The deposition speed was $4.5 \times 10^{-9}$ m/s (45 Å/sec). This deposition speed is 30 times larger than that obtained with a plasma CVD system alone, namely around $1.5 \times 10^{-10}$ m/s (1.5 Å/sec).

A dark conductivity of $4 \times 10^{-10}$ Scm$^{-1}$ and a

photo conductivity of $6 \times 10^{-5}$ Scm$^{-1}$ (AM:100mW/cm$^2$) was obtained as electric characteristics of an amorphous silicon layer thus produced which was devoid of dopant. These conductivities are equivalent to those obtained by a plasma CVD deposition system. If a solar cell were to be manufactured with a p-i-n junction, and the i-layer were to be fabricated according to the above-described method, then a high photoelectric conversion efficiency would be expected.

A non-monocrystalline semiconductor, $Si_xC_{1-x}$ - ($0<x<1$) of p-type conductivity could be fabricated largely under the same conditions as above-described except that as the productive gas, a reactive gas composed of $H_2Si(CH_3)_2/SiH_4 = 1/7$ and a gas composed of $B_2H_6/SiH_4 = 5/1000$ were introduced into the reaction space 1. The output power of the microwave oscillator 3 was 300 W. The substrate temperature was kept at 180°C under a pressure of $4 \times 10^{-2}$ Pa ($3 \times 10^{-4}$ torr). As a result, an optical energy gap of 2.4 eV and a dark conductivity of $3 \times 10^{-6}$ Scm$^{-1}$ was obtained.

For the manufacture of an n-type microcrystalline semiconductor, largely the same operating conditions might again be utilized except that the productive gas was $SiH_4/H_2 = 1/5$ to $1/40$, preferably $1/30$ at a pressure of $4 \times 10^{-2}$ Pa ($3 \times 10^{-4}$ torr). The output power of the microwave oscillator was 400 W. The substrate temperature was 250°C. As a result, an optical energy gap of 1.65 eV and an electric conductivity of 50 Scm$^{-1}$ was obtained. Because the ECR system has no sputtering effect even with high microwave power, the average crystal size tends to increase rendering a deposited layer more polycrystalline so that the crystallization rate is increased to 70% as compared to only 50% according to a glow discharge plasma CVD system. Further the semiconductor layer thus formed according to the experiment had a finely fabricated microcrystalline structure even with the reaction gas comprising $SiH_4/H_2 = 1/5$ to $1/40$.

A $SiO_{2-x}$ ($0 \leq x < 2$) or $Si_3N_{4-x}$ ($0 \leq x < 4$) layer was deposited by the method above described except that oxygen gas and nitrogen gas were introduced into the resonant space together with argon gas. Further $SiH_4$ gas was introduced into the reaction chamber 1 through the line 16. The ratio of the introduced oxygen gas or nitrogen gas to the introduced $SiH_4$ determines the value of X. When $X=0$ was desired corresponding to $SiO_2$ or $Si_3N_4$, an amount of oxygen gas or nitrogen gas equivalent to the amount of $SiH_4$ was introduced.

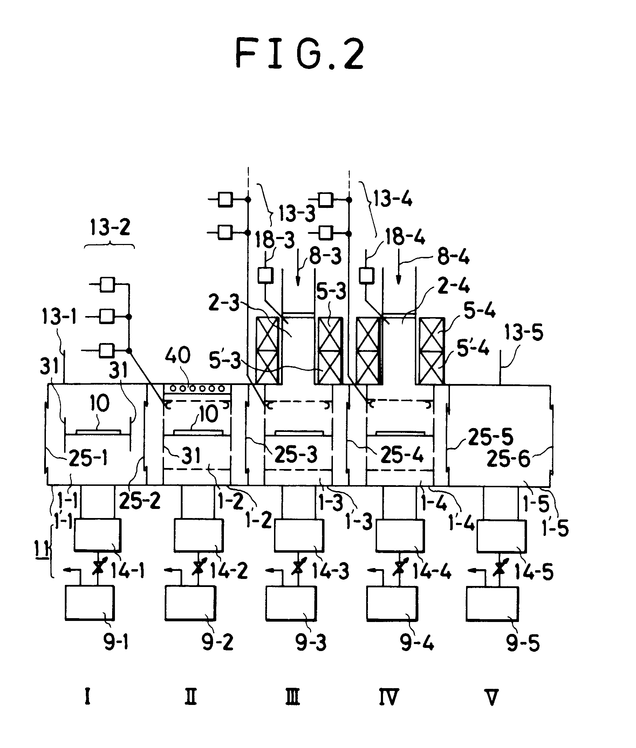

Referring now to Fig. 2, a system used in a method of the invention is shown. A semiconductor layer with a p-i-n junction or an n-i-p junction can be fabricated by means of the multi-chamber system.

The multi-chamber system as shown is comprised of five sections. The first section I is devoted to a loading chamber 1'-1. The second section II is devoted to a second chamber 1'-2, for example to deposit p-type layers. The third section III is devoted to a third chamber 1'-3, for example to deposit i-type layers. The fourth section IV is devoted to a fourth chamber 1'-4, for example to deposit n-type layers. The fifth section V is devoted to an unloading chamber 1'-5. For fabrication of n-i-p junctions, the sections II and IV would be interchanged.

Each chamber is provided with a doping system 13-1, 13-2,...13-5 and an evacuating system 11 comprising a turbo molecular pump 14-1, 14-2,...14-5 and a vacuum pump 9-1, 9-2,...9-5. Each of the intermediate three chambers is formed with a reaction space 1-2, 1-3, 1-4 respectively. The second section II is a photo CVD system which is provided with a mercury lamp 40 and halogen lamps disposed in opposed relation relative to each other in a direction perpendicular to the plane of the drawing with the reaction chamber therebetween. The third and fourth sections are ECR enhanced CVD systems each of which is configured as in Fig. 1 and is equipped with a Helmholtz coil 5-3, 5-4 and a microwave oscillator (not shown). Argon gas may be employed as a resonating gas, as above described, but hydrogen gas may also be used in which case the magnitude of the magnetic field would have to be increased in inverse proportion to molecular weight.

Gate valves 25-2, 25-3,...25-5 are disposed between adjacent chambers and the substrate holder 31 is arranged to be transported from one chamber to another through the respective gate valve when it is open. During deposition, of course, the valves are kept closed. The entrance valve 25-1 and the take-out valve 25-6 are, however, opened during deposition to enable new substrates to be loaded on to the holder in the loading chamber 1'-1 via the entrance valve and to enable the substrate which has been deposited upon in the chambers 1'-2, 1'-3 and 1'-4 to be removed.

The deposition processes in the reaction spaces 1-3 and 1-4 might be carried out according to the particular methods above described. After completion of deposition in the reaction spaces 1-2, 1-3 and 1-4, the supply of the productive gas and radiation of microwave energy are halted and the substrate holders 31 are transported by a transportation means (not shown in the figure) to the next adjacent chamber with the valves 25-1 and 25-6 closed. The transporting step is carried out swiftly without extracting the gaseous atmosphere inside each chamber. The resonating gas, argon gas, may or may not be continuously introduced. After the transportation is completed, the next deposition process is carried out respectively in the

chambers 1′-2, 1′-3 and 1′-4 with the valves 25-2 to 25-5 closed. By virtue of the above process, the semiconductor layers thus deposited are less contaminated and oxidized on their p-i and i-n junctions as compared with those formed by prior art glow discharge plasma CVD systems.

As an example, a solar cell thus formed might have a conversion efficiency of 12.9%, an open circuit voltage of 0.92 V and a short circuit current density of 18.4 mV/cm$^2$, with an effective area of 1.05 cm$^2$. Such a high conversion efficiency is possibly attributed to the fact that no sputtering with the reactive gas takes place in the ECR/CVD system. Further, it can be considered as another reason for the high conversion efficiency that the pressure in the chamber during deposition is only of the order of $1.333 \times 10^{-1}$ to $1.333 \times 10^{-3}$ Pa ($1 \times 10^{-3}$ to $1 \times 10^{-5}$ torr), $4 \times 10^{-2}$ Pa ($3 \times 10^{-4}$ torr) for example, which is lower than that obtained in a glow discharge plasma system, enabling impurity gas and reactive gas to be exhausted by the turbo pump after deposition in a time which is reduced by a factor of 100 in comparison with the time required in a glow discharge CVD system.

In the embodiment of Fig. 2, the gate valves 25-3 and 25-4 may be omitted from the system. In this case, buffer spaces might be provided between the respective chambers to improve the productivity of the system and the adjacent chambers might be substantially isolated by means of side walls of the holder 31. An exemplary solar cell fabricated according to this modification had a conversion efficiency of 12.6%, an open voltage of 0.93 V, a short current density of 18.3 mA/cm$^2$ and a fill factor of 0.81, with its area of 1.05 cm$^2$. Beside cost saving, it is made possible to transport the holder to the adjacent chamber within 5 minutes if the two valves 25-3 and 25-4 are dispensed with, thereby increasing the throughput of the system. Further, according to this embodiment, only one to three pinholes of about 0.1 to 0.01 micron in diameter are observed in the dark field of a microscope with a magnification factor of 100, which is 1/10 of that observed on a layer deposited by a glow discharge method.

The invention is also advantageous when applied to a process for manufacturing insulated-gate FETs of thin film type. In this case, the second section II is devoted to a reaction space in which is formed a semiconductor layer. The third section III is devoted to a reaction space in which is formed a silicon nitride layer. The fourth section IV is devoted to a reaction spaced in which is formed a silicon oxide layer. Each formation process is substantially the same as described supra.

It will be appreciated that various modifications could be made to the described embodiments without departing from the scope of the invention.

For example, a glow discharge CVD system could be employed as a second section II in the embodiment of Fig. 2 instead of the photo enhanced CVD system.

The present invention can be applied to light emitting MISs, super lattice light emitting devices and so on. As further applications, the invention is advantageous for other semiconductor lasers or optical integrated circuit devices.

As a productive gas, disilane or a mixture of monosilane and $Si_2F_6$ may be used. This would be expected to improve the deposition speed even more.

The substrate may be of silicon semiconductor, glass, synthetic resin, stainless steel or those which are provided with an electrode thereon.

As a semiconductor to be deposited, $Si_xGe_{1-x}$ ($0<x<1$), $Si_xSn_{1-x}$ ($0<x<1$), $C_xGe_{1-x}$ ($0<x<1$), either in their intrinsic or impurity doped semiconductor states can be used.

A substrate holder capable of holding a plurality of substrates as shown in Fig. 1 can be used for the multi-chamber system as shown in Fig. 2.

Reference is hereby directed to copending divisional patent application No. 91202023.7, which describes and claims certain aspects of the arrangements described above.

## Claims

1. A method of manufacturing a semiconductor device by chemical vapour reaction comprising the steps of:

    introducing a non-reactive gas into a first portion of a vacuum chamber;

    subjecting said non-reactive gas to a magnetic field;

    applying microwaves to said non-reactive gas to excite said non-reactive gas;

    mixing said non-reactive gas so energized with a reactive gas containing gaseous silicon and carbon compounds introduced into a second portion of said vacuum chamber to energize said reactive gas; and

    subjecting said reactive gas so energized to a glow discharge enhanced chemical vapour reaction, whereupon, by virtue of the dual energizing of said reactive gas, said reactive gas decomposes to deposit a layer mainly comprising $Si_xC_{1-x}$ ($0<X<1$) on a substrate placed in said vacuum chamber.

2. The method of claim 1 wherein said reactive gas contains a methyl silane.

3. The method of claim 2 wherein said reactive gas is a mixture of silane and a methyl silane.

4. The method of claim 2 or 3 wherein said methyl silane is dimethyl silane.

5. The method of any preceding claim wherein said reactive gas is a mixture of a silicide gas and carbide gas.

6. The method of any preceding claim wherein said $Si_xC_{1-x}$ semiconductor is formed as a p-type semiconductor by introducing a boron compound gas as a dopant gas.

7. The method of claim 6 wherein the dopant gas is introduced together with said reactive gas.

8. The method of claim 6 or 7 wherein said boron compound gas is diborane diluted with silane gas.

9. The method of claim 1 wherein said reactive gas includes a phosphorus compound gas as a dopant gas.

10. A method of manufacturing a semiconductor device by chemical vapour reaction comprising the steps of:

introducing a non-reactive gas into a first portion of a vacuum chamber;

subjecting said non-reactive gas to a magnetic field;

applying microwaves to said non-reactive gas to excite said non reactive gas and energize, under the existence of said magnetic field, charged particles of said non-reactive gas;

mixing said non-reactive gas so energized with a reactive gas containing gaseous silicon and germanium compounds introduced into a second portion of said vacuum chamber to energize said reactive gas; and

subjecting said reactive gas so energized to a glow discharge enhanced chemical vapour reaction, whereupon, by virtue of the dual energizing of said reactive gas, said reactive gas decomposes to deposit a layer mainly comprising $Si_xGe_{1-x}$ (0<X<1) on a substrate placed in said vacuum chamber.

11. A method of manufacturing a semiconductor device by chemical vapour reaction comprising the steps of:

introducing a non-reactive gas into a first portion of a vacuum chamber;

subjecting said non-reactive gas to a magnetic field;

applying microwaves to said non-reactive gas to excite said non-reactive gas and energize, under the existence of said magnetic field, charged particles of said non-reactive gas;

mixing said non-reactive gas so energized with a reactive gas containing gaseous silicon and tin comounds introduced into a second portion of said vacuum chamber to energize said reactive gas; and

subjecting said reactive gas so energized to a glow discharge enhanced chemical vapour reaction, whereupon, by virtue of the dual energising of said reactive gas, said reactive gas decomposes to deposit a layer mainly comprising $Si_xSn_{1-x}$ (0<X<1) on a substrate placed in said vacuum chamber.

12. A method of manufacturing a semiconductor device by chemical vapour reaction comprising the steps of:

introducing a non-reactive gas into a first portion of a vacuum chamber;

subjecting said non-reactive gas to a magnetic field;

applying microwaves to said non-reactive gas to excite said non-reactive gas and energize, under the existence of said magnetic field, charged particles of said non-reactive gas;

mixing said non-reactive gas so energized with a reactive gas containing gaseous carbon and germanium compounds introduced into a second portion of said vacuum chamber to energize said reactive gas; and

subjecting said reactive gas so energized to a glow discharge enhanced chemical vapour reaction, whereupon, by virtue of the dual energizing of said reactive gas, said reactive gas decomposes to deposit a layer mainly comprising $C_xGe_{1-x}$ (0<X<1) on a substrate placed in said vacuum chamber.

13. The method of any preceding claim wherein said first portion of said vacuum chamber comprises a resonating space subjected to said magnetic field and receiving said microwaves, and said second portion of said vacuum chamber comprises a reaction space intercommunicating with said resonating space and holding said substrate therein.

14. The method of any preceding claim wherein the energizing step of said non-reactive gas is carried out by electron cyclotron resonance.

15. A method as claimed in any preceding claim, wherein said chemical vapour reaction is carried out at a negative pressure which is maintained at less than 1.333 Pa ($10^{-2}$ Torr) by the cooperation of a vacuum pump and a turbo molecular pump,

**16.** The method of claim 15, wherein the negative pressure is maintained at less than 1.333 x $10^{-3}$ Pa ($10^{-5}$ Torr).

## Revendications

**1.** Procédé de fabrication d'un dispositif à semiconducteur par réaction chimique en phase vapeur comprenant les étapes consistant:

à introduire un gaz non réactif dans une première partie d'une chambre à vide;

à soumettre ledit gaz non réactif à un champ magnétique; à appliquer des micro-ondes audit gaz non réactif pour exciter ledit gaz non réactif;

à mélanger ledit gaz non réactif ainsi activé, avec un gaz réactif contenant des composés gazeux de carbone et de silicium gazeux introduit dans une seconde partie de ladite chambre à vide pour activer ledit gaz réactif; et

à soumettre ledit gaz réactif ainsi activé à une réaction chimique en phase vapeur, améliorée par décharge luminescente si bien que, en raison de la double activation dudit gaz réactif, ledit gaz réactif se décompose pour déposer une couche comprenant principalement $Si_xC_{1-x}$ (0<x<1) sur un substrat placé dans ladite chambre à vide.

**2.** Procédé selon la revendication 1, dans lequel ledit gaz réactif contient un méthyl silane.

**3.** Procédé selon la revendication 2, dans lequel ledit gaz réactif est un mélange de silane et d'un méthyl silane.

**4.** Procédé selon la revendication 2 ou 3, dans lequel ledit méthyl silane est du diméthyl silane.

**5.** Procédé selon l'une quelconque des revendications précédentes, dans lequel ledit gaz réactif est un mélange d'un siliciure gazeux et d'un carbure gazeux.

**6.** Procédé selon l'une quelconque des revendications précédentes, dans lequel ledit semi-conducteur $Si_xC_{1-x}$ est réalisé sous la forme d'un semiconducteur du type p par introduction d'un composé gazeux de bore en tant que gaz de dopage.

**7.** Procédé selon la revendication 6, dans lequel le gaz de dopage est introduit simultanément avec ledit gaz réactif.

**8.** Procédé selon la revendication 6 ou 7, dans lequel ledit composé gazeux de bore est du diborane dilué avec un silane gazeux.

**9.** Procédé selon la revendication 1, dans lequel ledit gaz réactif comprend un composé gazeux de phosphore en tant que gaz de dopage.

**10.** Procédé de fabrication d'un dispositif à semiconducteur par réaction chimique en phase vapeur comprenant les étapes consistant:

à introduire un gaz non réactif dans une première partie d'une chambre à vide;

à soumettre ledit gaz non réactif à un champ magnétique;

à appliquer des micro-ondes audit gaz non réactif pour exciter ledit gaz non réactif et activer, en présence dudit champ magnétique, des particules chargées dudit gaz non réactif;

à mélanger ledit gaz non réactif ainsi activé avec un gaz réactif contenant des composés gazeux de germanium et de silicium introduit dans une seconde partie de ladite chambre à vide pour activer ledit gaz réactif; et

à soumettre ledit gaz réactif ainsi activé à une réaction chimique en phase vapeur, améliorée par décharge luminescente si bien que, en raison de la double activation dudit gaz réactif, ledit gaz réactif se décompose pour déposer une couche comprenant principalement $Si_xGe_{1-x}$ (0<x<1) sur un substrat placé dans ladite chambre à vide.

**11.** Procédé de fabrication d'un dispositif à semiconducteur par réaction chimique en phase vapeur comprenant les étapes consistant:

à introduire un gaz non réactif dans une première partie d'une chambre à vide;

à soumettre ledit gaz non réactif à un champ magnétique;

à appliquer des micro-ondes audit gaz non réactif pour exciter ledit gaz non réactif et activer, en présence dudit champ magnétique, des particules chargées dudit gaz non réactif;

à mélanger ledit gaz non réactif ainsi activé avec un gaz réactif contenant des composés gazeux d'étain et de silicium introduit dans une seconde partie de ladite chambre à vide pour activer ledit gaz réactif; et

à soumettre ledit gaz réactif ainsi activé à une réaction chimique en phase vapeur, améliorée par décharge luminescente si bien que, en raison de la double activation dudit gaz réactif, ledit gaz réactif se décompose pour déposer une couche comprenant principalement $Si_xSn_{1-x}$ (0<X<1) sur un substrat placé dans ladite chambre à vide.

**12.** Procédé de fabrication d'un dispositif à semiconducteur par réaction chimique en phase vapeur comprenant les étapes consistant:

à introduire un gaz non réactif dans une première partie d'une chambre à vide;

à soumettre ledit gaz non réactif à un champ magnétique;

à appliquer des micro-ondes audit gaz non réactif pour exciter ledit gaz non réactif et activer, en présence dudit champ magnétique, des particules chargées dudit gaz non réactif;

à mélanger ledit gaz non réactif ainsi activé avec un gaz réactif contenant des composés gazeux de germanium et de carbone introduit dans une seconde partie de ladite chambre à vide pour activer ledit gaz réactif; et

à soumettre ledit gaz réactif ainsi activé à une réaction chimique en phase vapeur, améliorée par décharge luminescente si bien que, en raison de la double activation dudit gaz réactif, ledit gaz réactif se décompose pour déposer une couche comprenant principalement $C_xGe_{1-x}$ (0<x<1) sur un substrat placé dans ladite chambre à vide.

**13.** Procédé selon l'une quelconque des revendications précédentes dans lequel ladite première partie de ladite chambre à vide comprend un espace de résonance soumis audit champ magnétique et recevant lesdites micro-ondes, et ladite seconde partie de ladite chambre à vide comprend un espace de réaction intercommuniquant avec ledit espace de résonance et contenant ledit substrat.

**14.** Procédé selon l'une quelconque des revendications précédentes, dans lequel l'étape d'activation dudit gaz non réactif est effectuée par résonance électronique de cyclotron.

**15.** Procédé selon l'une quelconque des revendications précédentes, dans lequel ladite réaction chimique en phase vapeur est effectuée à une pression négative qui est maintenue à moins de 1,333 Pa ($10^{-2}$ torr) par la coopération d'une pompe à vide et d'une pompe turbomoléculaire.

**16.** Procédé selon la revendication 15, dans lequel la pression négative est maintenue à moins de $1,333 \times 10^{-3}$ Pa ($10^{-5}$ torr).

**Patentansprüche**

**1.** Verfahren zur Herstellung eines Halbleiterbausteins mittels einer chemischen Gasphasen-Reaktion, gekennzeichnet durch folgende Schritte:

ein nicht-reaktives Gas in einen ersten Abschnitt einer Vakuumkammer einleiten;

das nicht-reaktive Gas einem Magnetfeld aussetzen;

das nicht-reaktive Gas einer Mikrowellenstrahlung aussetzen, um es anzuregen;

das derart angeregte nicht-reaktive Gas mit einem reaktiven, gasförmige Silizium- und Kohlenstoffverbindungen enthaltenden Gas vermischen, das in einen zweiten Abschnitt der Vakuumkammer eingeleitet wird, zur Anregung des reaktiven Gases; und

das derart angeregte reaktive Gas einer glimmentladungsverstärkten chemischen Gasphasen-Reaktion unterwerfen, wodurch sich das reaktive Gas aufgrund seiner doppelten Anregung zur Bildung einer hauptsächlich $Si_xC_{1-x}$ (0 < x < 1) enthaltenden Schicht auf einem in der Vakuumkammer angeordneten Substrat aufspaltet.

**2.** Verfahren nach Anspruch 1, wobei das reaktive Gas Methylsilan enthält.

**3.** Verfahren nach Anspruch 2, wobei das reaktive Gas eine Mischung aus Silan und einem Methylsilan ist.

**4.** Verfahren nach Anspruch 2 oder 3, wobei das Methylsilan Dimethylsilan ist.

**5.** Verfahren nach einem der vorhergehenden Ansprüche, wobei das reaktive Gas eine Mischung eines Silizidgases und eines Karbidgases ist.

**6.** Verfahren nach einem der vorhergehenden Ansprüche, wobei der $Si_xC_{1-x}$-Halbleiter als Halbleiter des p-Typs durch die Einführung eines Gases einer Borverbindung als Dotiergas gebildet ist.

**7.** Verfahren nach Anspruch 6, wobei das Dotiergas zusammen mit dem reaktiven Gas eingeführt wird.

**8.** Verfahren nach Anspruch 6 oder 7, wobei das Gas der Borverbindung mit Silangas verdünntes Diboran ist.

**9.** Verfahren nach Anspruch 1, wobei das reaktive Gas ein Gas einer Phosphorverbindung als Dotiergas enthält.

**10.** Verfahren zur Herstellung eines Halbleiterbausteins mittels einer chemischen Gasphasen-Reaktion, gekennzeichnet durch folgende Schritte:

ein nicht-reaktives Gas in einen ersten Abschnitt einer Vakuumkammer einleiten;

das nicht-reaktive Gas einem Magnetfeld aussetzen;

das nicht-reaktive Gas einer Mikrowellenstrahlung aussetzen, um es anzuregen und geladene Partikel des nicht-reaktiven Gases unter der Einwirkung des Magnetfelds anzuregen;

das derart angeregte nicht-reaktive Gas mit einem reaktiven, gasförmige Silizium- und Germaniumverbindungen enthaltenden Gas vermischen, das in einen zweiten Abschnitt der Vakuumkammer eingeleitet wird, zur Anregung des reaktiven Gases; und

das derart angeregte reaktive Gas einer glimmentladungsverstärkten chemischen Gasphasen-Reaktion unterwerfen, wodurch sich das reaktive Gas aufgrund seiner doppelten Anregung zur Bildung einer hauptsächlich $Si_xGe_{1-x}$ (0 < x < 1) enthaltenden Schicht auf einem in der Vakuumkammer angeordneten Substrat aufspaltet.

11. Verfahren zur Herstellung eines Halbleiterbausteins mittels einer chemischen Gasphasen-Reaktion, gekennzeichnet durch folgende Schritte:

ein nicht-reaktive Gas in einen ersten Abschnitt einer Vakuumkammer einleiten;

das nicht-reaktive Gas einem Magnetfeld aussetzen;

das nicht-reaktive Gas einer Mikrowellenstrahlung aussetzen, um es anzuregen und geladene Partikel des nicht-reaktiven Gases unter der Einwirkung eines Magnetfelds anzuregen;

das derart angeregte nicht-reaktive Gas mit einem reaktiven, gasförmige Silizium- und Zinnverbindungen enthaltenden Gas vermischen, das in einen zweiten Abschnitt der Vakuumkammer eingeleitet wird, zur Anregung des reaktiven Gases; und

das derart angeregte reaktive Gas einer glimmentladungsverstärkten chemischen Gasphasen-Reaktion unterwerfen, wodurch sich das reaktive Gas aufgrund seiner doppelten Anregung zur Bildung einer hauptsächlich aus $Si_xSn_{1-x}$ (0 < x < 1) enthaltenden Schicht auf einem in der Vakuumkammer angeordneten Substrat aufspaltet.

12. Verfahren zur Herstellung eines Halbleiterbausteins mittels einer chemischen Gasphasen-Reaktion, gekennzeichnet durch folgende Schritte:

ein nicht-reaktives Gas in einen ersten Abschnitt einer Vakuumkammer einleiten;

das nicht-reaktive Gas einem Magnetfeld aussetzen;

das nicht-reaktive Gas einer Mikrowellenstrahlung aussetzen, um es anzuregen und geladene Partikel des nicht-reaktiven Gases unter der Einwirkung eines Magnetfelds anzuregen;

das derart angeregte nicht-reaktive Gas mit einem reaktiven, gasförmige Kohlenstoff- und Germaniumverbindungen enthaltenden Gas vermischen, das in einem zweiten Abschnitt der Vakuumkammer eingeleitet wird, zur Anregung des reaktiven Gases; und

das derart angeregte reaktive Gas einer glimmentladungsverstärkten chemischen Gasphasen-Reaktion unterwerfen, wodurch sich das reaktive Gas aufgrund seiner doppelten Anregung zur Bildung einer hauptsächlich aus $C_xGe_{1-x}$ (0 < x < 1) bestehenden Schicht auf einem in der Vakuumkammer angeordneten Substrat aufspaltet.

13. Verfahren nach einem der vorherigen Ansprüche, wobei der erste Abschnitt der Vakuumkammer einen Resonanzraum umfaßt, der dem Magnetfeld ausgesetzt ist und die Mikrowellenstrahlung empfängt, und der zweite Abschnitt der Vakuumkammer einen mit dem Resonanzraum kommunizierenden und das Substrat enthaltenden Reaktionsraum umfaßt.

14. Verfahren nach einem der vorherigen Ansprüche, wobei der Anregungsschritt des nicht-reaktiven Gases mittels ElektronenZyklotronresonanz erfolgt.

15. Verfahren nach einem der vorherigen Ansprüche, wobei die chemische Gasphasenreaktion bei Unterdruck durchgeführt wird, der durch das Zusammenwirken einer Vakuumpumpe und einer Turbomolekularpumpe auf weniger als 1,333 Pa ($10^{-2}$ Torr) gehalten wird.

16. Verfahren nach Anspruch 15, wobei der Unterdruck auf weniger als 1,333 x $10^{-3}$ Pa ($10^{-5}$ Torr) gehalten wird.

# F I G.1

# FIG.2